# EUROPEAN PATENT SPECIFICATION

(11) **EP 0 829 192 B1**
(45) Date of publication and mention of the grant of the patent: **17.09.2003**
(21) Application number: 97902544.2
(22) Date of filing: 26.02.1997
(51) Int. Cl.: H05K 13/04

(54) **METHOD OF PLACING A COMPONENT ON A SUBSTRATE AND COMPONENT PLACEMENT MACHINE FOR CARRYING OUT THE METHOD**
BESTÜCKUNGSVERFAHREN VON BAUELEMENTEN AUF EINEM SUBSTRAT UND BESTÜCKAUTOMAT DAFÜR
PROCEDE POUR PLACER UN COMPOSANT SUR UN SUBSTRAT ET MACHINE DE PLACEMENT DE COMPOSANT POUR REALISER CE PROCEDE

(30) Priority: 27.03.1996 EP 96200829
(43) Date of publication of application: 18.03.1998
(73) Proprietor: Assembléon N.V., 5652 AH Eindhoven (NL)
(72) Inventor: OTTEN, Joseph, Gertrudis, Leonardus, NL-5656 AA Eindhoven (NL)
(74) Representative: Bos, Kornelis Sjoerd
(86) International application number: IB9700167
(87) International publication number: WO97038567

(56) References cited:
- US-A- 4 738 025
- US-A- 4 980 971
- US-A- 5 084 959

## Description

The invention relates to a method of placing a component onto a substrate, in which, after a component has been picked up by a placement head secured to an arm of a robot, the component is moved into an image field of a stationary first imaging device and the component is imaged, a second imaging device, which is also secured to said arm of the robot, images a mark of the substrate, after which the position of the component and the position where the component is to be placed onto the substrate are calculated from the resulting image data and the placement head subsequently places the component onto the substrate at the desired position.

Such a method is known from US-A-5,084,959. In this known method the position of the component relative to the second imaging device is calculated after an image of the component has been made by means of the first imaging device. This is possible since a reference point of the placement head is always moved to a fixed position in the image field of the first imaging device and the distance between the reference point of the placement head and a reference point of the second imaging device is known. However, in practice this distance is not always found to be constant, which gives rise to an inaccuracy in the placement of the component on the substrate. The fact that this distance is not constant is caused in particular by temperature differences. However, other influences, such as undesired vibrations, may also give rise to erroneous measurements.

It is an object of the invention to place a component at the desired position on a substrate with a high accuracy.
To this end, the invention is characterized in that during imaging of the component the first imaging device also images at least one mark situated on a reference plate and at the same time the second imaging device images at least one other mark on the reference plate, after which the position of the component relative to the second imaging device is calculated from the resulting image data.
The advantage of this method is that the position of the component picked up by the placement head relative to the second imaging device can be determined during the placement process of each component on the substrate. The desired position where the component is to be placed on the substrate is determined by means of the second imaging device. By means of the data of these two positions the robot can direct the placement head with the component exactly to the desired position in order to place the component.
Preferably, for imaging the component the component is positioned at substantially the same image distance as the first mark.

The invention also relates to a component placement machine comprising a frame, a robot, a transport system for the transport of substrates, a placement head for placing components onto the substrate, which placement head is secured to an arm of the robot, a first imaging device, which is fixedly connected to the frame, for determining the position of the component, and a second imaging device, which moves along with the placement head, for detecting a mark of the substrate.
In order to place a component at the desired position on the substrate with a higher accuracy, the placement machine is characterized in that the placement machine comprises a reference plate having at least a first mark and a second mark, which marks are situated at a fixed distance from one another and which first mark is situated within the image field of the first imaging device during imaging of the component, while at the same time the second mark is situated within the image field of the second imaging device. The marks on the reference plate have been applied with a very high accuracy. Their exact position relative to one another is stored in an image processor, which calculates the instantaneous position of the component with the aid of the image data.
Preferably, the reference plate has an opening which allows a component picked up by the placement head to pass through and the reference plate has at least one first mark adjacent the opening. This enables the component to be positioned in the opening in such a manner that the component, particularly contact faces or pins thereof, are disposed in the same image plane of the imaging device as that in which the mark of the reference plate is situated.
Moreover, the reference plate is preferably disposed at substantially the same level as the substrate. This raises the imaging accuracy and hence the placement accuracy of the component.

The invention will now be described in more detail with reference to an exemplary embodiment shown in the drawings, in which
Fig. 1 shows a component placement machine for carrying out the method,
Fig. 2 is a plan view showing a reference plate and a substrate, and
Fig. 3 is a side view of the placement head and the imaging devices in a position for imaging.

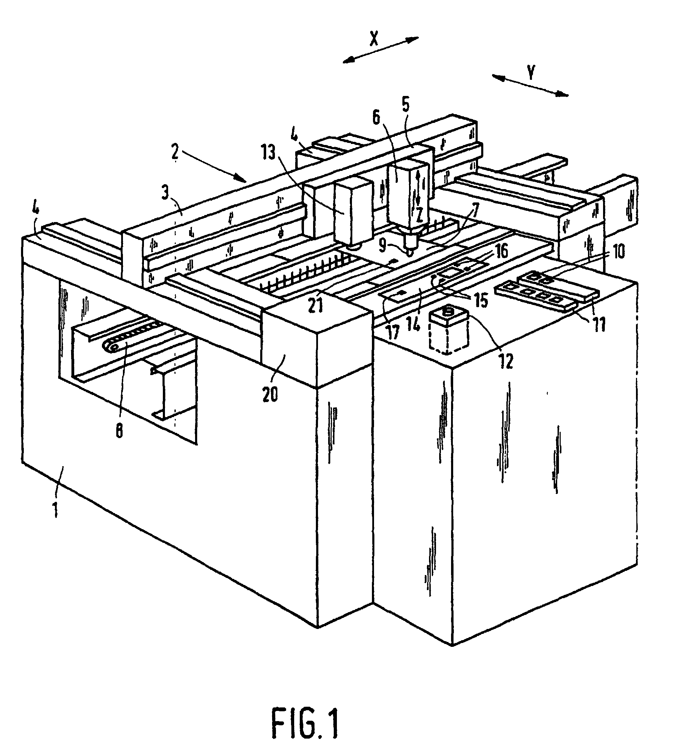

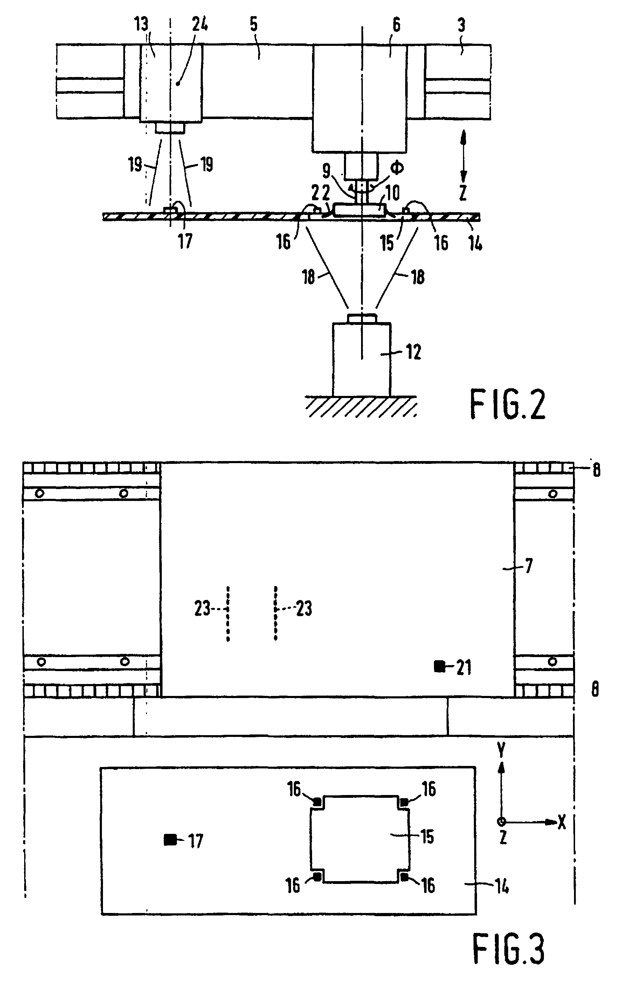

The component placement machine in Fig. 1 comprises a machine frame 1 carrying an X-Y robot 2. The robot is formed by a slide 3, which is movable in the Y-direction over two parallel guide members 4 of the frame and which is movable along the slide 3 in the X direction by means of an arm 5. The arm carries a component placement head 6. The machine has a transport mechanism for the transport of substrates, for example printed circuit boards, through the machine. Of this transport mechanism only the conveyor belt 8 is shown. The component placement head 6 comprises a suction nozzle 9 by means of which components 10 are picked up from a component feeder 11, which are subsequently placed onto the substrate 7. The suction nozzle can be driven in a Z direction and a φ direction. In the φ direction means that the nozzle can perform an angular rotation φ about its longitudinal axis. In order to place the components very accurately at the desired position on a substrate, the machine comprises a first imaging device 12, which is fixedly secured to the frame, and a second imaging device 13, which is secured to the arm 5 of the robot, adjacent the placement head. The machine further comprises a reference plate 14. The reference plate has an opening 15. This opening is so large that the component can pass through the opening. Near the opening the reference plate has first marks 16, in then present example four. The reference plate has a second mark 17 at some distance from the opening. The second mark has a very accurate and known position relative to the first marks. The stationary first imaging device 12 is disposed underneath the opening 15 of the reference plate. Both the opening 15 and the first marks 16 surrounding this opening are situated within the image field 18 of the imaging device. The reference plate is preferably made of a transparent material. The method of placing a component onto a substrate will be described hereinafter with reference to Figures 2 and 3.
The robot is first directed to the component feeder 11, where the suction nozzle 9 of the placement head 6 picks up a component 10 with the aid of a partial vacuum. The placement head 6 is then positioned above the reference plate 14 and the component is moved into the opening 15 of the reference plate. At this instant the second mark 17 is within the image field 19 of the second imaging device 13. The first imaging device 12 now images the component 10 and the marks 16 surrounding it and the second imaging device 13 images the second mark 17. These images are made at the same time. The image data is applied to an image processor 20, which calculates the instantaneous position of the component relative to the second imaging device. Subsequently, the robot positions the second imaging device 13 above a mark 21 of the substrate 7. The position of this mark 21 relative to the position where the component is to be placed onto the substrate is know accurately and is stored in the image processor. Now the second imaging device 13 images the second mark 21 on the substrate and applies the resulting image data to the image processor. The image processor calculates the position of the second imaging device 13 relative to the position where the component is to be placed onto the substrate. Since the position of the component relative to the second imaging device is also known, the relative position of the component with respect to the position where the component is to be mounted on the substrate is now also known accurately, in the X, Y and Z directions and in the φ direction. By means of this data the placement head 6 can be directed accurately to the desired position in order to place the component 10 onto the substrate 7. In practice, the position of the component is generally defined by the positions of the contact pins 22 and the position of the substrate, with which the contact pins should make contact, is defined by the positions of the contact pads 23. For determining the position relative to the second imaging device this device has a reference point 24.
The reference plate does not require an opening in order to image the component. However, the advantage of an opening is that the component can be positioned in the opening, as a result of which the component and the mark of the reference plate are disposed at substantially the same level and, consequently, at the same image distance from the imaging device. This results in an increased accuracy of the measurement. Preferably, the reference plate is disposed at the same level as the substrate.
The imaging sequence is not essential. For example, it is also possible that first a mark of the substrate is imaged and subsequently the component is imaged.

## Claims

1. A method of placing a component (10) onto a substrate (7), in which, after a component has been picked up by a placement head (6) secured to an arm (5) of a robot, the component is moved into an image field of a stationary first imaging device (12) and the component is imaged, a second imaging device (13), which is also secured to said arm of the robot, images a mark (21) of the substrate, after which the position of the component and the position where the component is to be placed onto the substrate are calculated from the resulting image data and the placement head subsequently places the component onto the substrate at the desired position, **characterized in that** during imaging of the component the first imaging device (12) also images at least one mark (16) situated on a reference plate (14) and at the same time the second imaging device (13) images at least one other mark (17) on the reference plate (14), after which the position of the component relative to the second imaging device is calculated from the resulting image data.

2. A method of placing a component onto a substrate as claimed in Claim 1, **characterized in that** for imaging the component the component is positioned at substantially the same image distance as the first mark.

3. A component placement machine comprising a frame, a robot, a transport system for the transport of substrates (7), a placement head (6) for placing components (10) onto the substrate, which placement head is secured to an arm (5) of the robot, a first imaging device (12), which is fixedly connected to the frame, for determining the position of the component, and a second imaging device (13), which moves along with the placement head, for detecting a mark (21) of the substrate, **characterized in that** the placement machine comprises a reference plate (14) having at least a first mark (16) and a second mark (17) which marks are situated at a fixed distance from one another and which first mark (16) is situated within the image field of the first imaging device (12) during imaging of the component, while at the same time the second mark (17) is situated within the image field of the second imaging device (13).

4. A component placement machine as claimed in Claim 3, **characterized in that** the reference plate has an opening which allows a component picked up by the placement head to pass through and the reference plate has at least one first mark adjacent the opening.

5. A component placement machine as claimed in Claim 3, **characterized in that** reference plate is disposed at substantially the same level as the substrate.

## Patentansprüche

1. Verfahren zum Anbringen eines Bauelementes (10) auf einem Substrat (7), wobei, nachdem ein Bauelement von einem Bestückungskopf (6), der an einem Arm (5) von einem Robotor befestigt ist, aufgenommen worden ist, dieses Bauelement in eine Bildfeld einer ortsfesten ersten Bilderzeugungsanordnung (12) gebracht wird und das Bauelement abgebildet wird, eine zweite Bilderzeugungsanordnung (13), die ebenfalls an dem genannten Arm des Roboters befestigt ist, eine Markierung (21) des Substrats abbildet, wonach die Lage des Bauelementes und die Position, wo das Bauelement auf dem Substrat angeordnet werden soll, aus den resultierenden Bilddaten berechnet werden und der Bestückungskopf daraufhin das Bauelement an der gewünschten Stelle auf das Substrat setzt, **dadurch gekennzeichnet, dass** bei der Abbildung des Bauelementes die erste Bilderzeugungsanordnung (12) ebenfalls wenigstens eine Markierung (16) auf einer Bezugsplatte (14) abbildet und gleichzeitig die zweite Bilderzeugungsanordnung (13) wenigstens eine andere Markierung (17) auf der Bezugsplatte (14) abbildet, wonach die Lage des Bauelementes gegenüber der zweiten Bilderzeugungsanordnung aus den resultierenden Bilddaten berechnet wird.

2. Verfahren zum Anbringen eines Bauelementes auf einem Substrat nach Anspruch 1, **dadurch gekennzeichnet, dass** zum Abbilden des Bauelementes das Bauelement in nahezu denselben Bildabstand wie die erste Markierung gebracht wird.

3. Bestückungsautomat mit einem Rahmen, einem Roboter, einem Transportsystem zum Transportieren der Substrate (7), einem Bestückungskopf (6) zum Platzieren von Bauelementen (10) auf das Substrat, wobei dieser Bestückungskopf an einem Arm (5) des Roboters befestigt ist, mit einer ersten Bilderzeugungsanordnung (12), die mit dem Rahmen ortsfest verbunden ist, zum Ermitteln der Lage des Bauelementes, und mit einer zweiten Bilderzeugungsanordnung (13) die sich zusammen mit dem Bestückungskopfverlagert um eine Markierung (21) des Substrats zu detektieren, **dadurch gekennzeichnet, dass** der Bestückungsautomat eine Bezugsplatte (14) mit wenigstens einer ersten Markierung (16) und einer zweiten Markierung (17) aufweist, wobei diese Markierungen sich in einem festen Abstand voneinander befinden und wobei die erste Markierung (16) während der Abbildung des Bauelementes innerhalb des Bildfeldes der ersten Bilderzeugungsanordnung (12) liegt, während gleichzeitig die zweite Markierung (17) innerhalb des Bildfeldes der zweiten Bilderzeugungsanordnung (13) liegt.

4. Bestückungsautomat nach Anspruch 3, **dadurch gekennzeichnet, dass** die Bezugsplatte eine Öffnung aufweist, durch die ermöglicht wird, dass ein von dem Bestückungskopf aufgenommenes Bauelement durch diese Öffnung hindurch geführt wird, und dass die Bezugsplatte wenigstens eine erste Markierung neben der Öffnung aufweist.

5. Bestückungsautomat nach Anspruch 3, **dadurch gekennzeichnet, dass** die Bezugsplatte auf nahezu demselben Pegel wie das Substrat liegt.

## Revendications

1. Procédé pour la mise en place d'un composant (10) sur un substrat (7), selon lequel, après la prise d'un composant par une tête de mise en place (6) fixée à un bras (5) d'un robot, le composant est déplacé dans un champ d'image d'un premier dispositif de reproduction d'images stationnaire (12) et une image du composant est reproduite, un deuxième dispositif de reproduction d'images (13), qui est également fixé audit bras du robot, reproduit l'image d'une marque (21) du substrat, après quoi la position du composant et la position où doit être placé le composant sur le substrat sont calculées à partir des données de l'image en résultante et la tête de mise en place met ensuite le composant à la position désirée sur le substrat, **caractérisé en ce que**, lors de la reproduction de l'image du composant, le premier dispositif de reproduction d'images (12) reproduit également l'image d'au moins une marque (16) située sur une plaque de référence (14) et en même temps le deuxième dispositif de reproduction d'images (13) reproduit l'image d'au moins une autre marque (17) sur une plaque de référence (14), après quoi la position du composant par rapport au deuxième dispositif de reproduction d'images est calculée à partir des données de l'image en résultante.

2. Procédé pour la mise en place d'un composant sur un substrat selon la revendication 1, **caractérisé en ce que** pour la reproduction de l'image du composant, le composant est positionné à pratiquement la même distance d'image que la première marque.

3. Dispositif de mise en place d'un composant comprenant un châssis, un robot, un système de transport pour le transport de substrats (7), une tête de mise en place (6) pour la mise en place de composants (10) sur le substrat, laquelle tête de mise en place est fixée à un bras (5) du robot, un premier dispositif de reproduction d'images (12), qui est fixé au châssis, pour déterminer la position du composant, et un deuxième dispositif de reproduction d'images (13), qui se déplace le long de la tête de mise en place, pour la détection d'une marque (21) du substrat, **caractérisé en ce que** le dispositif de mise en place de composant est muni d'une plaque de référence (14) présentant au moins une première marque (16) et une deuxième marque (17), lesquelles marques sont situées à une distance fixe l'une par rapport à l'autre et laquelle première marque (16) est située dans le champ d'image du premier dispositif de reproduction d'images (12) pendant la reproduction de l'image du composant, alors qu'en même temps la deuxième marque (17) est située dans le champ d'image du deuxième dispositif de reproduction d'images (13).

4. Dispositif de mise en place d'un composant comme revendiqué dans la revendication 3, **caractérisé en ce que** la plaque de référence est munie d'une ouverture par laquelle peut passer un composant pris par la tête de mise en place de composant et la plaque de référence est munie d'au moins une première marque prévue à côté de l'ouverture.

5. Dispositif de mise en place d'un composant comme revendiqué dans la revendication 3, **caractérisé en ce que** la plaque de référence est disposée pratiquement au même niveau que le substrat.
